# EUROPEAN PATENT APPLICATION

(11) **EP 4 653 955 A2**
(43) Date of publication of application: **26.11.2025**
(21) Application number: 25176298.5
(22) Date of filing: 14.05.2025
(51) Int. Cl.: G03F 7/09, G03F 7/11, G03F 7/42

(54) **COMPOUND FOR FORMING METAL-CONTAINING FILM, COMPOSITION FOR FORMING METAL-CONTAINING FILM, AND PATTERNING PROCESS**

(30) Priority: 21.05.2024 JP 2024082746
(71) Applicant: SHIN-ETSU CHEMICAL CO., LTD., Tokyo 1000005 (JP)
(72) Inventor: Kobayashi, Naoki, Niigata (JP); Nagamachi, Nobuhiro, Niigata (JP); Ishiwata, Kenta, Niigata (JP); Kori, Daisuke, Niigata (JP)
(74) Representative: Schicker, Silvia

(57) **Abstract**

The present invention is a compound for forming a metal-containing film, containing: at least one metal atom selected from the group consisting of Ti, Zr, and Hf; and a ligand coordinated to the metal atom via an oxygen atom, where the ligand has a cyclic structure (t) selected from a ring having 4 or more carbon atoms and containing 1 or more oxygen atoms, a ring having 3 or more carbon atoms and containing 2 or more oxygen atoms, and a ring having 3 or more carbon atoms and containing 1 or more oxygen atoms and 1 or more heteroatoms other than oxygen atoms. This can provide: a compound for forming a metal-containing film that gives a resist middle layer film that makes it possible to obtain an excellent pattern profile, has high adhesiveness to a resist upper layer film, and suppresses fine-pattern collapse in a fine patterning process of a semiconductor device manufacturing process; a composition for forming a metal-containing film, containing the compound; and a patterning process using the composition.

## Description

### TECHNICAL FIELD

The present invention relates to: a compound for forming a metal-containing film; a composition for forming a metal-containing film, containing the compound; and a patterning process using the composition.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and there is a problem that the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

As a silicon-containing resist middle layer film used in a three-layer resist method like the method described above, used are: a silicon-containing inorganic film obtained by CVD, for example, an SiO₂ film (e.g. Patent Document 2) or an SiON film (e.g. Patent Document 3); a film obtained by spin-coating, such as an SOG (spin-on-glass) film (e.g. Patent Document 4 and Non Patent Document 1) or a crosslinkable silsesquioxane film (e.g. Patent Document 5); etc. A polysilane film (e.g. Patent Document 6) should also be usable. Among these films, an SiO₂ film and an SiON film have high performance as dry etching masks when the organic film underneath is dry-etched, but require special equipment for film formation. On the other hand, an SOG film, a crosslinkable silsesquioxane film, and a polysilane film can be formed just by spin-coating and heating, and are thought to have high process efficiency.

There are some problems with such silicon-containing films, conventionally used in multilayer resist methods. For example, when a resist pattern is to be formed by photolithography, it is well known that exposure light is reflected off a substrate and interferes with incident light, causing a problem in so-called standing waves, and therefore, in order to obtain a fine pattern having no edge roughness of the resist film under the most advanced ArF immersion and high-NA exposure conditions, an antireflective function is essential in a middle layer film. Furthermore, in the most advanced semiconductor processes described above, the thinning of photoresists has progressed considerably, and therefore, middle layer films are also required to be thinned. In next-generation exposure processes, it is required to provide an antireflective effect with a film thickness of 30 nm or less. In addition, dry etching speed when using oxygen gas plasma, which is commonly used when processing a resist underlayer film, is preferably low, so as to increase the etching selectivity between a middle layer film and an underlayer film, and in the course of thinning, middle layer films are required to have improved dry etching resistance.

As resist middle layer films that satisfy such requirements for an anti-reflective effect and dry etching property, metal hard mask films containing Ti or Zr are attracting attention, in place of conventional silicon-containing films. TiO₂ and ZrO₂ are known as high refractive index materials, and it is possible to enhance an antireflective effect under high-NA exposure conditions by these materials being contained in a film. In addition, excellent dry etching resistance to oxygen gas can be expected by metal-oxygen bonds being included.

Moreover, metal hard mask films have excellent dry etching resistance not only to oxygen gas but also to fluorine gas, and therefore, excellent dry etching resistance can also be expected in two-layer resist methods where a metal hard mask film is formed as a resist underlayer film on a substrate to be processed, and a resist upper layer film is formed thereon.

On the other hand, when such a metal hard mask film is used directly under a resist upper layer film, the improvement of adhesiveness to a resist pattern is a problem. A cured metal hard mask film has much higher surface energy (or a smaller contact angle with water) than a photoresist applied subsequently. This mismatch in surface energy causes adhesion failure between the metal hard mask film and the subsequently applied photoresist, and brings about pattern collapse.

Surface modification of the metal hard mask film is necessary for suppressing photoresist pattern collapse on the metal hard mask film, and for example, Patent Document 7 reports a metal hard mask containing a surface-modified organic polymer. It is reported that, by using the difference between the free energies of the organic polymer and the metal compound and allowing the organic polymer to be unevenly distributed on a surface layer, adhesiveness to a resist pattern can be improved. For suppressing pattern collapse, used are organic polymers including surface-treated moieties selected from hydroxyl, protected hydroxyl, protected carboxyl, and mixtures thereof. However, in the current situation, where finer pattern formation is required, it cannot be said that these materials have sufficient pattern collapse suppression performance. In addition, when an organic polymer is contained, there is a risk of dry etching resistance to oxygen gas being degraded, and therefore, there are demands for the development of a compound for forming a metal-containing film excellent in adhesiveness to a resist upper layer film.

Nowadays, it is considered that interaction between a resist upper layer film and an underlayer film directly under the resist upper layer film in a fine pattern at the interface also has an influence on the sensitivity of the resists, pattern profile (rectangularity and residue in space portions), etc., and improved performance is required in the underlayer film directly under the resist upper layer film from these viewpoints as well (Non Patent Document 2).

### CITATION LIST

### PATENT LITERATURE

Patent Document 1: JP2004-205685A
Patent Document 2: JPH7-183194A
Patent Document 3: JPH7-181688A
Patent Document 4: JPH5-291208A
Patent Document 5: JP2005-520354A
Patent Document 6: JPH11-60735A
Patent Document 7: JP6463600B2

### NON PATENT LITERATURE

Non Patent Document 1: J. Appl. Polym. Sci., Vol. 88, 636-640 (2003)
Non Patent Document 2: Proc. SPIE Vol. 7273, 72731J (2009)

### SUMMARY OF INVENTION

### TECHNICAL PROBLEM

The present invention has been made in view of the above-described circumstances. An object of the present invention is to provide: a compound for forming a metal-containing film that gives a resist middle layer film that makes it possible to obtain an excellent pattern profile, has high adhesiveness to a resist upper layer film, and suppresses fine-pattern collapse in a fine patterning process of a semiconductor device manufacturing process; a composition for forming a metal-containing film, containing the compound; and a patterning process using the composition.

### SOLUTION TO PROBLEM

To achieve the object, the present invention provides a compound for forming a metal-containing film, comprising:
at least one metal atom selected from the group consisting of Ti, Zr, and Hf; and a ligand coordinated to the metal atom via an oxygen atom, wherein
the ligand has a cyclic structure (t) selected from
a ring having 4 or more carbon atoms and containing 1 or more oxygen atoms,
a ring having 3 or more carbon atoms and containing 2 or more oxygen atoms, and
a ring having 3 or more carbon atoms and containing 1 or more oxygen atoms and 1 or more heteroatoms other than oxygen atoms.

When such a compound for forming a metal-containing film is contained in a composition for forming a metal-containing film, adhesiveness to a resist upper layer film can be enhanced, and a rectangular resist pattern profile can be achieved after exposure and development. Thus, the substrate can be processed to have a fine pattern.

The cyclic structure (t) preferably contains a ring having 4 or more carbon atoms and containing 2 or more oxygen atoms, or a ring having 4 or more carbon atoms and containing 1 or more oxygen atoms and 1 or more heteroatoms other than oxygen atoms.

When such a compound for forming a metal-containing film is contained in a composition for forming a metal-containing film, adhesiveness to a resist upper layer film can be further enhanced, and a rectangular resist pattern profile can be achieved after exposure and development. Thus, the substrate can be processed to have a fine pattern.

The cyclic structure (t) preferably forms a polycyclic structure by being bonded to any one or more of: a cyclic hydrocarbon having 4 to 6 carbon atoms and optionally containing a heteroatom; a cyclic hydrocarbon having 5 or 6 carbon atoms, having one or more carbon-carbon double bonds, and optionally containing a heteroatom; an aromatic ring; and an aromatic heterocycle.

When such a compound for forming a metal-containing film is contained in a composition for forming a metal-containing film, heat resistance can be enhanced, adhesiveness to a resist upper layer film can be further enhanced, and a rectangular resist pattern profile can be achieved after exposure and development. Thus, the substrate can be processed to have a fine pattern.

The cyclic structure (t) is preferably a derivative of an organic acid containing the cyclic structure (t).

Such a ligand exhibits a strong coordination effect to a metal atom, and therefore, when contained in a composition for forming a metal-containing film, a composition excellent in storage stability can be provided.

The organic acid is preferably a derivative of a carboxylic acid.

Such a ligand exhibits a strong coordination effect to a metal atom, and therefore, when contained in a composition for forming a metal-containing film, a composition excellent in storage stability can be provided. The ligand is also preferable from the viewpoint of the availability of raw materials.

The ligand is preferably a derivative of the following structure.

Ra(X)ₙCOOH (1)

In the formula, Ra represents a monovalent organic group containing the cyclic structure (t); X represents a group selected from a substituted or unsubstituted alkylene group having 1 to 10 carbon atoms, a substituted or unsubstituted, branched alkylene group having 3 to 10 carbon atoms, a substituted or unsubstituted alkylene group having 2 to 10 carbon atoms and containing a carbon-carbon double bond, and a substituted or unsubstituted, branched alkylene group having 3 to 10 carbon atoms and containing a carbon-carbon double bond; and "n" represents 0 or 1.

When such a compound for forming a metal-containing film is contained in a composition for forming a metal-containing film, adhesiveness to a resist upper layer film can be enhanced even more, and a rectangular resist pattern profile can be achieved after exposure and development. Thus, the substrate can be processed to have a fine pattern.

The compound for forming a metal-containing film preferably further comprises a ligand which is a derivative of a silicon compound represented by the following general formula (w), 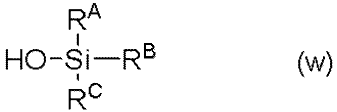 wherein R^{A}, R^{B}, and R^{C} each represent any organic group selected from an organic group having 2 to 30 carbon atoms including a crosslinking group of a structure represented by any of the following general formulae (w-1) to (w-3), a substituted or unsubstituted alkyl group having 1 to 20 carbon atoms, and an aryl group having 6 to 20 carbon atoms, 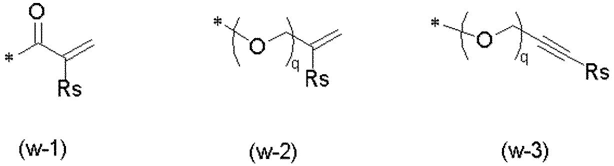 wherein Rₛ represents a hydrogen atom or a monovalent organic group having 1 to 10 carbon atoms; "q" represents 0 or 1; and "*" represents an attachment point.

When the compound further contains a ligand which is a derivative of a silicon compound represented by the general formula (w), the stability of the metal compound in a solution can be enhanced.

The compound for forming a metal-containing film is preferably a reaction product of: a metal compound represented by the following formula (a) or a metal-containing compound containing any of a hydrolysate, condensate, and hydrolysis condensate of the metal compound represented by the following formula (a); and a compound having the cyclic structure (t),

**LₐMX_{b}** **(a)**

wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b is 2 to 4, "a" and "b" each representing an integer of 0 to 4.

When such a metal compound is used, it is possible to form a metal-containing film having better dry etching resistance to fluorine gas and oxygen gas.

The formula (a) preferably has a structure of the following formula (a-1),

M(OR^{1A})₄ (a-1)

wherein M represents any of Ti, Zr, and Hf; and R^{1A} represents a monovalent organic group having 1 to 20 carbon atoms.

The metal compound, having such a structure, is preferable from the viewpoints of productivity and the availability of raw materials.

The present invention also provides a composition for forming a metal-containing film, the composition functioning as a metal-containing film material used in manufacturing a semiconductor, the composition comprising: (A) the above-described compound for forming a metal-containing film; and (B) an organic solvent.

Such a composition for forming a metal-containing film has better dry etching resistance than conventional resist underlayer film materials, and can also form a metal-containing film excellent in wet peeling property.

The composition can further comprise one or more of (C) a crosslinking agent, (D) an acid generator, and (E) a surfactant.

When the composition for forming a metal-containing film contains one or more of such additives, the composition for forming a metal-containing film has better coating property, dry etching resistance, and filling and/or planarizing properties.

The organic solvent (B) preferably contains, as (B1) a high-boiling-point solvent, one or more kinds of organic solvent having a boiling point of 180°C or higher.

When flowability is imparted to the compound for forming a metal-containing film by a high-boiling-point solvent being contained, it is possible to suppress the generation of coating defects induced by the composition for forming a metal-containing film being dry.

The present invention also provides a patterning process for forming a pattern in a substrate to be processed, comprising the steps of:
(I-1) applying the inventive composition for forming a metal-containing film directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching directly or indirectly while using the resist upper layer film having the formed pattern as a mask; and
(I-5) processing the substrate to be processed directly or indirectly while using the metal-containing film having the formed pattern as a mask to form the pattern in the substrate to be processed.

Such a patterning process can be used suitably for patterning processes such as multilayer resist processes.

In the inventive patterning process, at least one organic resist underlayer film can be included between the substrate to be processed and the metal-containing film.

According to such a patterning process, a pattern can be transferred to the substrate to be processed with high accuracy.

In the inventive patterning process, the resist upper layer film is preferably formed directly on the metal-containing film.

A metal-containing film formed using the inventive compound for forming a metal-containing film has excellent adhesiveness to a resist upper layer film, and therefore, makes it possible to obtain a highly rectangular resist upper layer film pattern.

The inventive patterning process can further comprise, after a step of processing a film directly under the metal-containing film while using the metal-containing film as a mask to form the pattern, a step of removing the metal-containing film with a chemical solution.

According to such a patterning process, the metal-containing film can be removed easily while suppressing damage to the substrate, and therefore, it is possible to form a pattern excellent in the rectangularity of the cross-sectional shape.

A solution containing a hydrogen peroxide solution and an acid or a solution containing a base, a hydrogen peroxide solution, and water is preferably used as the chemical solution.

Such a chemical solution can easily remove a metal-containing film formed using the inventive compound for forming a metal-containing film.

### ADVANTAGEOUS EFFECTS OF INVENTION

As described above, the inventive compound for forming a metal-containing film contains a ligand having a particular cyclic structure (t), and therefore, when a metal-containing film is formed using the compound, adhesiveness to a resist upper layer film can be enhanced, and a rectangular resist pattern profile can be achieved after exposure and development. Therefore, a composition for forming a metal-containing film containing the compound for forming a metal-containing film and a patterning process using the composition can be used suitably in patterning processes such as multilayer resist processes.

### BRIEF DESCRIPTION OF DRAWINGS

FIG. 1 is an explanatory diagram of an example (three-layer resist process) of the inventive patterning process.
FIG. 2 is an explanatory diagram of an example (three-layer resist process) of the inventive patterning process using wet peeling.

### DESCRIPTION OF EMBODIMENTS

As explained above, there have been demands for the development of: a compound for forming a metal-containing film, having high adhesiveness to a resist upper layer film and having an advantageous effect of suppressing fine pattern collapse; a composition for forming a metal-containing film containing the compound; and a patterning process using the composition.

A metal-containing film formed by using a conventional compound for forming a metal-containing film has much higher surface energy (or a smaller contact angle with water) than a photoresist applied subsequently. This mismatch in surface energy causes adhesion failure between the metal-containing film and the subsequently applied photoresist, and brings about pattern collapse. In addition, in a case where an organic polymer is contained as a surface modifier, the dry etching resistance when processing an organic underlayer film is insufficient, and there is a risk of pattern transfer failure being induced.

The present inventors have studied the above-described object earnestly and found out that the object can be achieved by a compound for forming a metal-containing film containing a ligand having a particular structure, a composition for forming a metal-containing film containing the compound, and a patterning process using the composition, and completed the present invention.

That is, the present invention is a compound for forming a metal-containing film, comprising:
at least one metal atom selected from the group consisting of Ti, Zr, and Hf; and a ligand coordinated to the metal atom via an oxygen atom, wherein
the ligand has a cyclic structure (t) selected from
a ring having 4 or more carbon atoms and containing 1 or more oxygen atoms,
a ring having 3 or more carbon atoms and containing 2 or more oxygen atoms, and
a ring having 3 or more carbon atoms and containing 1 or more oxygen atoms and 1 or more heteroatoms other than oxygen atoms.

Hereinafter, the present invention will be described in detail, but the present invention is not limited thereto.

### <Compound for Forming Metal-Containing Film>

The present invention is a compound for forming a metal-containing film, containing:
at least one metal atom selected from the group consisting of Ti, Zr, and Hf; and a ligand coordinated to the metal atom via an oxygen atom, where
the ligand has a cyclic structure (t) selected from
a ring having 4 or more carbon atoms and containing 1 or more oxygen atoms,
a ring having 3 or more carbon atoms and containing 2 or more oxygen atoms, and
a ring having 3 or more carbon atoms and containing 1 or more oxygen atoms and 1 or more heteroatoms other than oxygen atoms.

Here, in the cyclic structure (t), the number of carbon atoms meant in the ring having 4 or more carbon atoms and containing 1 or more oxygen atoms etc. indicates the number of carbon atoms that directly contribute to the formation of a single cyclic structure containing the 1 or more oxygen atoms, and does not include the number of carbon atoms that contribute to the formation of adjacent cyclic structures.

The cyclic structure (t) is a structure selected from a ring having 4 or more carbon atoms and containing 1 or more oxygen atoms, a ring having 3 or more carbon atoms and containing 2 or more oxygen atoms, and a ring having 3 or more carbon atoms and containing 1 or more oxygen atoms and 1 or more heteroatoms other than oxygen atoms; preferably a cyclic structure having 4 to 6 carbon atoms. The cyclic structure may have one or more unsaturated bonds, and may be a cyclic structure that is a heterocyclic aromatic structure. Such a cyclic structure can provide a metal compound excellent in storage stability in a composition, and is therefore preferable.

When such a metal compound is contained in a composition for forming a metal-containing film, the composition has better dry etching resistance than conventional resist underlayer film materials, and it is possible to form a metal-containing film excellent in adhesiveness to a resist upper layer film.

Examples of preferable structures of the cyclic structure (t) include the following.

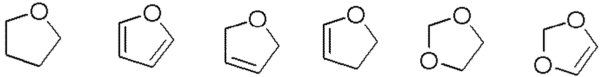

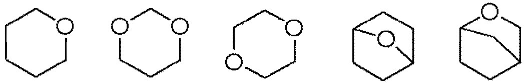

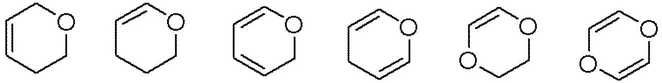

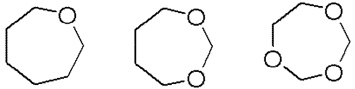

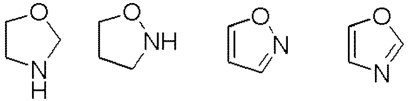

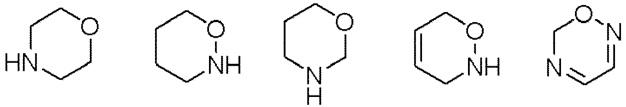

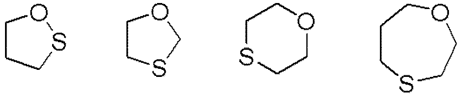

The ligand has a cyclic structure (t) selected from a ring having 4 or more carbon atoms and containing 1 or more oxygen atoms, a ring having 3 or more carbon atoms and containing 2 or more oxygen atoms, and a ring having 3 or more carbon atoms and containing 1 or more oxygen atoms and 1 or more heteroatoms other than oxygen atoms, and preferably has a cyclic structure containing 2 or more oxygen atoms or a cyclic structure (t-1) containing 1 or more oxygen atoms and 1 or more heteroatoms other than oxygen atoms. That is, the cyclic structure (t) preferably contains a ring having 4 or more carbon atoms and containing 2 or more oxygen atoms, or a ring having 4 or more carbon atoms and containing 1 or more oxygen atoms and 1 or more heteroatoms other than oxygen atoms.

When the ligand includes the cyclic structure (t-1), the adhesiveness to a resist upper layer film can be further improved, and in addition, an excellent resist pattern profile can be formed when development is performed with an alkaline developer or an organic developer and a rectangular resist pattern can be transferred to a layer underneath by dry etching performed subsequently. The heteroatom other than an oxygen atom is not particularly limited as long as it is not an oxygen atom, but is preferably a nitrogen atom or a sulfur atom, more preferably a nitrogen atom.

The cyclic structure (t) preferably forms a polycyclic structure by being bonded to any one or more of: a cyclic hydrocarbon having 4 to 6 carbon atoms and optionally containing a heteroatom; a cyclic hydrocarbon having 5 or 6 carbon atoms, having one or more carbon-carbon double bonds, and optionally containing a heteroatom; an aromatic ring; and an aromatic heterocycle. Examples of the polycyclic structure include condensed rings, bicyclic, tricyclic, and bridge-structure-containing condensed rings, condensed rings including a bridged ring and containing a heteroatom, and spiro rings.

When the ligand contains a polycyclic structure, heat resistance is enhanced, and adhesiveness to a resist upper layer film can be further enhanced.

The polycyclic structure preferably does not contain an acid anhydride unit. When no acid anhydride units are contained, there is no risk of an acid anhydride structure ring-opening during synthesis of a metal compound and being coordinated to a metal atom, and thus, when the compound is contained in a composition for forming a metal-containing film, there are no problems with adhesiveness to a resist upper layer film.

The ligand is preferably a derivative of an organic acid. That is, the cyclic structure (t) is preferably a derivative of an organic acid containing the cyclic structure (t). The organic acid is preferably any of a carboxylic acid, a sulfonic acid, a phosphinic acid, and a phosphonic acid, more preferably a carboxylic acid from the viewpoint of the coordination effect to a metal atom and the availability of raw materials, and more specifically, the ligand is preferably a derivative of the following structure.

Ra(X)ₙCOOH (1)

In the formula, Ra represents a monovalent organic group containing the cyclic structure (t); X represents a group selected from a substituted or unsubstituted alkylene group having 1 to 10 carbon atoms, a substituted or unsubstituted, branched alkylene group having 3 to 10 carbon atoms, a substituted or unsubstituted alkylene group having 2 to 10 carbon atoms and containing a carbon-carbon double bond, and a substituted or unsubstituted, branched alkylene group having 3 to 10 carbon atoms and containing a carbon-carbon double bond; and "n" represents 0 or 1.

In the formula (1), X represents a group selected from a substituted or unsubstituted alkylene group having 1 to 10 carbon atoms, a substituted or unsubstituted, branched alkylene group having 3 to 10 carbon atoms, a substituted or unsubstituted alkylene group having 2 to 10 carbon atoms and containing a carbon-carbon double bond, and a substituted or unsubstituted, branched alkylene group having 3 to 10 carbon atoms and containing a carbon-carbon double bond, preferably a substituted or unsubstituted, linear alkylene group having 1 to 10 carbon atoms or a substituted or unsubstituted alkylene group having 2 to 10 carbon atoms and containing a carbon-carbon double bond, and more preferably an unsubstituted alkylene group having 1 to 5 carbon atoms.

Examples of preferable structures of the Ra in the formula (1) include the following.

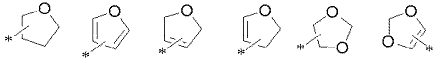

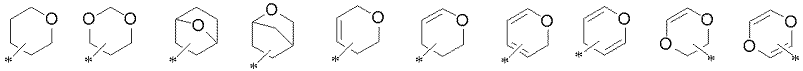

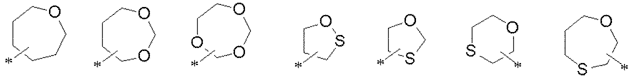

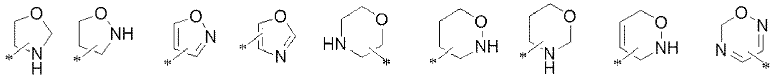

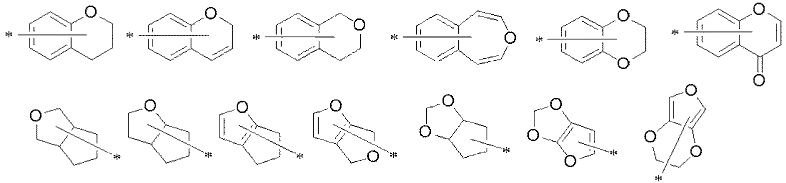

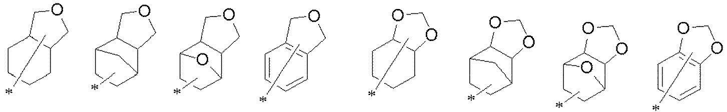

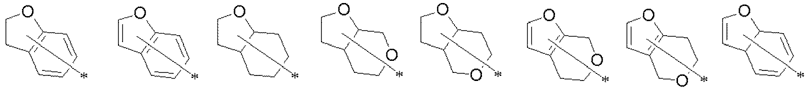

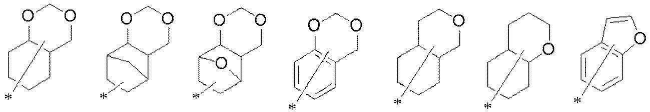

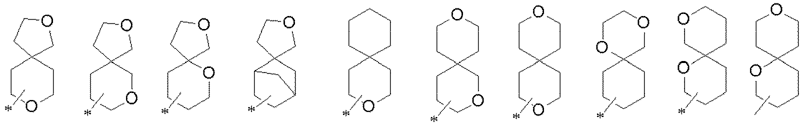

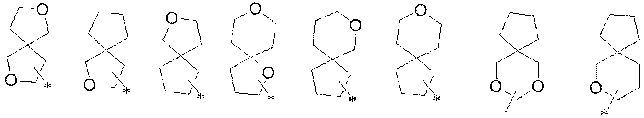

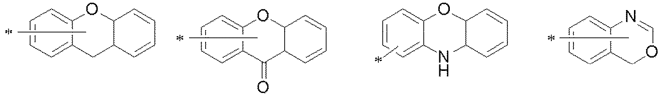

The "*" represents an attachment point to X.

From the viewpoint of the availability of raw materials, the "n" in the formula (1) is preferably 0.

The compound for forming a metal-containing film is preferably a reaction product of: a metal compound represented by the following formula (a) or a metal-containing compound containing any of a hydrolysate, condensate, and hydrolysis condensate of the metal compound represented by the following formula (a); and a compound having the cyclic structure (t).

**LₐMX_{b}** **(a)**

In the formula, M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b is 2 to 4, "a" and "b" each representing an integer of 0 to 4.

Such a compound for forming a metal-containing film makes it possible to form a metal-containing film excellent in dry etching resistance to fluorine gas and oxygen gas when the compound is contained in a composition for forming a metal-containing film.

### [(a) Metal-Containing Compound]

### (Hydrolysable Group)

Examples of the hydrolysable group X of the formula (a) include halogen atoms, alkoxy groups, carboxylate groups, acyloxy groups, and -NR¹R². R¹ and R² preferably each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR¹R² include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### (Monodentate Ligand)

Examples of the monodentate ligand include a hydroxo ligand, a carboxy ligand, an amido ligand, an amine ligand, an ammonia ligand, an olefin ligand, etc.

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligand include pyridine, a trimethylamine ligand, a piperidine ligand, etc.

Examples of the olefin ligand include: chain olefins, such as ethylene and propylene; cyclic olefins, such as cyclopentene, cyclohexene, and norbornene; etc.

### (Polydentate Ligand)

Examples of the polydentate ligand include a ligand derived from a hydroxy acid ester, a ligand derived from a β-diketone, a ligand derived from a β-keto ester, a ligand derived from an α,α-dicarboxylic acid ester, a hydrocarbon having a π bond, diphosphine, etc.

Examples of the hydroxy acid ester include glycolic acid esters, lactic acid esters, 2-hydroxycyclohexane-1-carboxylic acid esters, salicylic acid esters, etc.

Examples of the β-diketone include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid ester include malonic acid diesters, α-alkyl-substituted malonic acid diesters, α-cycloalkyl-substituted malonic acid diesters, α-aryl-substituted malonic acid diesters, etc.

Examples of the hydrocarbon having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino) ferrocene, etc.

In the general formula (a), a+b is 2 to 4, and "a" and "b" each represent an integer of 0 to 4. As "a", 0 to 4 are favorable, 2 and 4 are preferable. As "b", 0 to 4 are favorable, and 0, 2, and 4 are preferable. By setting "a" and "b" to be within the above ranges, the stability of the compound for forming a metal-containing film can be enhanced.

Preferable examples of the metal compound represented by the formula (a) include the following.

Examples of compounds containing titanium include diisopropoxybis(2,4-pentanedionate)titanium(IV), tetra-n-butoxytitanium(IV), tetra-n-propoxytitanium(IV), titanium(IV)tetraisopropoxide, tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV).

Examples of compounds containing zirconium include dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono (2, 4-pentanedionate) zirconium (IV), triisopropoxymono (2,4-pentanedionate) zirconium (IV), tri(3-methacryloxypropyl)methoxyzirconium(IV), and tri(3-acryloxypropyl)methoxyzirconium(IV).

Examples of compounds containing hafnium include diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV).

Among the above, metal alkoxide, metal carboxylate, and metal acetate are more preferable, and from the viewpoint of the availability of raw materials, the structure of the following formula (a-1) is further preferable.

M(OR^{1A})₄ (a-1)

In the formula, M represents any of Ti, Zr, and Hf; and R^{1A} represents a monovalent organic group having 1 to 20 carbon atoms.

In the formula (a-1), R^{1A} represents a monovalent organic group having 1 to 20 carbon atoms, preferably a methyl group, an ethyl group, an n-propyl group, an i-propyl group, an n-butyl group, or a t-butyl group, and more preferably an isopropyl group, an n-butyl group, or a t-butyl group.

At the time of the synthesis reaction of the compound for forming a metal-containing film, a compound that may become a monodentate ligand or a polydentate ligand (hereinafter, compound (b) for forming a ligand) in the compound for forming a metal-containing film can be contained besides the metal compound (a).

Examples of the compound (b) for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the L in the general formula (a). Examples also include compounds having multiple hydroxy groups etc.

In the compound for forming a metal-containing film, the ligand having the cyclic structure (t) is preferably contained in an amount of 10 mol% to 90 mol%, more preferably 20 mol% to 80 mol%, and further preferably 25 mol% to 75 mol% of the total amount of ligands coordinated to the metal atoms. A ligand other than the ligand of the compound having the cyclic structure (t), for example, a ligand derived from the compound (b) for forming a ligand or an alkoxy group having 1 to 10 carbon atoms is preferably contained in an amount of 0 mol% to 90 mol%, more preferably 20 mol% to 80 mol% of the total amount of ligands coordinated to the metal atoms.

Furthermore, on the occasion of the synthesis reaction of the compound for forming a metal-containing film, a silicon-containing compound (c) may be contained besides the compound (b) for forming a ligand.

By substituting a hydrolysable group of the metal compound (a) with the silicon-containing compound, it is possible to enhance the stability of the compound for forming a metal-containing film in the composition for forming a metal-containing film.

Examples of the silicon-containing compound (c) include a structure of the following formula (w).

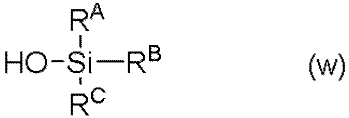

In the formula, R^{A}, R^{B}, and R^{C} each represent any organic group selected from an organic group having 2 to 30 carbon atoms and having any crosslinking group of structures represented by the following general formulae (w-1) to (w-3), a substituted or unsubstituted alkyl group having 1 to 20 carbon atoms, and an aryl group having 6 to 20 carbon atoms.

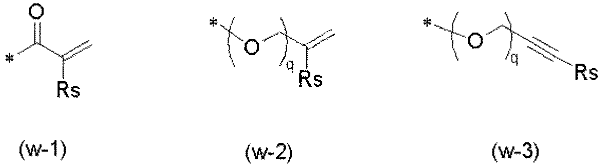

In the general formula (w-1) to (w-3), Rₛ represents a hydrogen atom or a monovalent organic group having 1 to 10 carbon atoms; "q" represents 0 or 1; and "*" represents an attachment point.

The silicon-containing compound (c) is preferably any compound of the following formulae, and from the viewpoint of productivity, trimethylsilanol is more preferable.

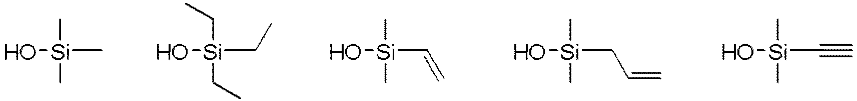

When the compound for forming a metal-containing film contains the ligand having the cyclic structure (t) and the ligand derived from the silicon-containing compound (c), the amount of the ligand having the cyclic structure (t) contained in the compound for forming a metal-containing film is preferably 10 mol% to 100 mol%, more preferably 20 mol% to 80 mol%, and further preferably 25 mol% to 75 mol% of the total amount of ligands coordinated to the metal atoms. The ligand derived from the silicon-containing compound (c) is preferably contained in an amount of 10 mol% to 90 mol%, more preferably 20 mol% to 80 mol%, and further preferably 25 mol% to 75 mol% of the total amount of ligands coordinated to the metal atoms. Ligands other than the ligands of the compound (b) for forming a ligand and the silicon-containing compound (c), for example, a ligand derived from an alkoxy group having 1 to 10 carbon atoms, are preferably contained in an amount of 0 mol% to 90 mol%, more preferably 0 mol% to 75 mol% of the total amount of ligands coordinated to the metal atoms.

The method for synthesizing the compound for forming a metal-containing film is not particularly limited. For example, a metal alkoxide, a metal carboxylate, or a metal acetylacetonate (acac) can be used as the metal compound (a), and the compound for forming a metal-containing film can be obtained by allowing the alkoxy, carboxy, or acac metal to react with the ligand having the cyclic structure (t). The metal compound (a) may be subjected to hydrolysis condensation and then the product may be allowed to react with the ligand having the cyclic structure (t), or the metal compound (a) may be allowed to react with the ligand having the cyclic structure (t) and then the product may be subjected to hydrolysis condensation. If it is difficult to control the hydrolysis condensation, the reaction with the ligand having the cyclic structure (t) may be performed in a non-hydrous environment. The methods are preferably adjusted appropriately in accordance with the properties required in the compound for forming a metal-containing film and the metal-containing film. When the silicon-containing compound (c) and the compound having the cyclic structure (t) are to be contained as ligands, it is preferable to allow the metal compound (a) and the silicon-containing compound (c) to react and then allow the product to react with the ligand having the cyclic structure (t).

As a method for performing a hydrolysis condensation reaction using the metal compound (a), examples include a method of subjecting the metal compound (a) to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the metal compound (a) etc., on the molar basis. The upper limit of the amount of the water is preferably 20-fold, more preferably 15-fold, and further preferably 10-fold on the molar basis.

The solvent used in the synthesis reaction of the compound for forming a metal-containing film is not particularly limited, and for example, a solvent given as an example of the organic solvent (B) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at a ratio of 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### <Composition for Forming Metal-Containing Film>

The present invention also provides a composition for forming a metal-containing film, the composition functioning as a metal-containing film material used in manufacturing a semiconductor, the composition containing: (A) the above-described compound for forming a metal-containing film; and (B) an organic solvent.

### <(B) Organic Solvent>

The organic solvent (B) usable in the inventive composition for forming a metal-containing film is not particularly limited as long as the organic solvent is capable of dissolving the compound (A) for forming a metal-containing film, and when contained, (C) a crosslinking agent, (D) an acid generator, (E) a surfactant, other additives, etc. described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the compound (A) for forming a metal-containing film.

### <(B1) High-Boiling-Point Solvent>

In the inventive composition for forming a metal-containing film, the organic solvent (B) may contain (B1) a high-boiling-point solvent.

That is, the organic solvent (B) preferably contains, as the high-boiling-point solvent (B1), one or more kinds of organic solvent having a boiling point of 180°C or higher.

For example, it is possible to use, as the organic solvent (B), a mixture of one or more kinds of organic solvent having a boiling point of lower than 180°C and one or more kinds of organic solvent having a boiling point of 180°C or higher (high-boiling-point solvent (B1)).

The high-boiling-point solvent (B1) is not particularly limited to hydrocarbons, alcohols, ketones, esters, ethers, or chlorine-based solvents, as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the inventive composition for forming a metal-containing film is heat-treated, etc. The boiling point of the high-boiling-point solvent (B1) is preferably 180°C to 300°C, further preferably 200°C to 300°C. When the boiling point is as described, there is no risk of the evaporation rate at the baking (heating) being excessively fast, and therefore, it is possible to suppress the generation of dryness-induced defects at the time of film formation. Moreover, there is no risk of a solvent having such a boiling point remaining in the film without evaporating after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### <Other Components>

The above-described composition may further contain one or more of (C) a crosslinking agent, (D) an acid generator, and (E) a surfactant.

In the following, components other than the compound (A) for forming a metal-containing film and the organic solvent (B) that may be contained in the inventive composition for forming a metal-containing film will be described.

### [(C) Crosslinking Agent]

The inventive composition for forming a metal-containing film can also contain a crosslinking agent (C) to increase curability and further inhibit intermixing with a resist upper layer film. The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (C) can be used, or two or more kinds thereof can be used in combination, and when the crosslinking agent is contained, the contained amount is preferably 5 to 50 parts by mass, more preferably 10 to 40 parts by mass based on 100 parts by mass of the compound (A) for forming a metal-containing film. When the contained amount is 5 parts by mass or more, sufficient curability can be exhibited, and intermixing with a resist upper layer film can be suppressed. Meanwhile, when the contained amount is 50 parts by mass or less, there is no risk of degradation in dry etching resistance due to the proportion of the compound (A) for forming a metal-containing film in the composition being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis(4,5-diphenyl-2-oxazoline), 2,2'-methylene bis(4-phenyl-2-oxazoline), 2,2'-methylene bis(4-tert-butyl-2-oxazoline), 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

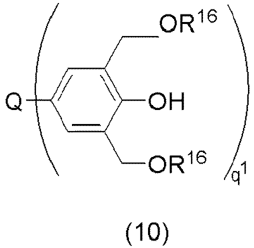

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a q¹-valent hydrocarbon group having 1 to 20 carbon atoms. "q¹" represents an integer of 1 to 5, more preferably 2 or 3. Specific examples of Q include groups obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compounds represented by the general formula (10) include the following compounds. Among these, hexamethoxymethylated derivatives of triphenolmethane, triphenolethane, 1,1,1,-tris(4-hydroxyphenyl)ethane, and tris(4-hydroxyphenyl)-1-ethyl-4-isopropylbenzene are preferable from the viewpoint of improving the curability and film thickness uniformity of the metal-containing film.

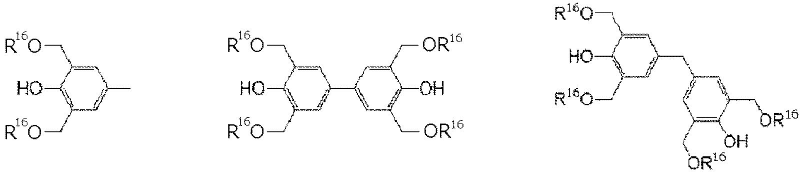

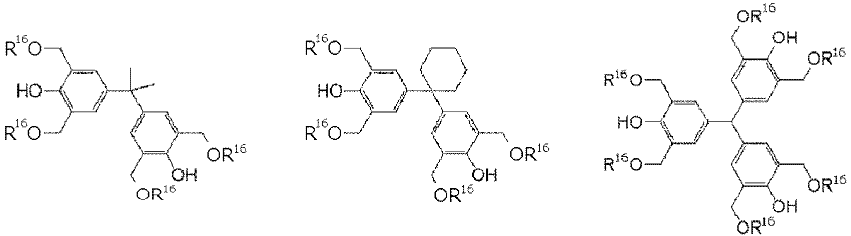

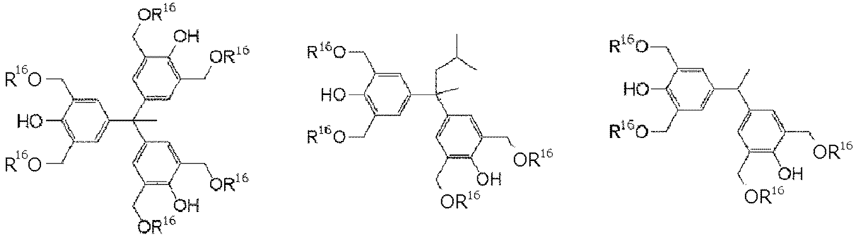

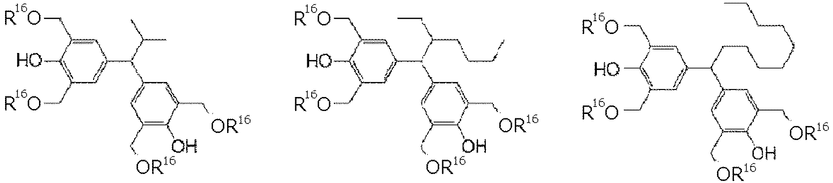

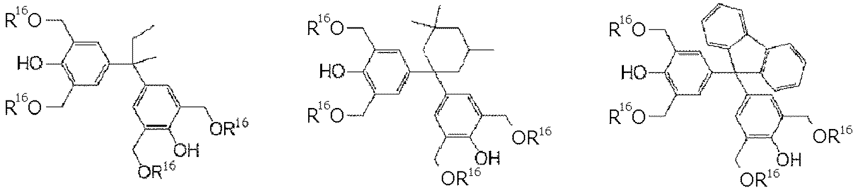

In the formulae, R¹⁶ is as in the formula (10).

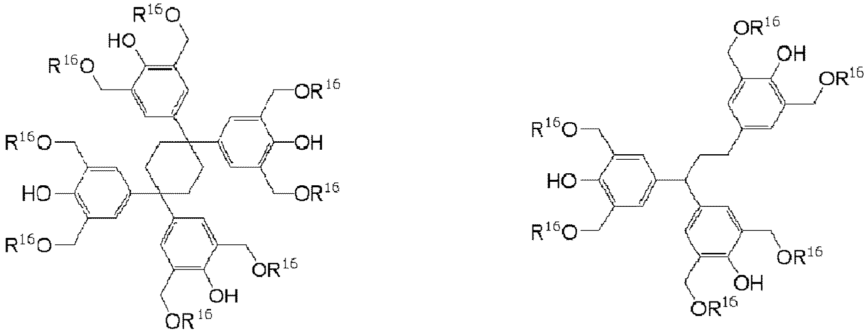

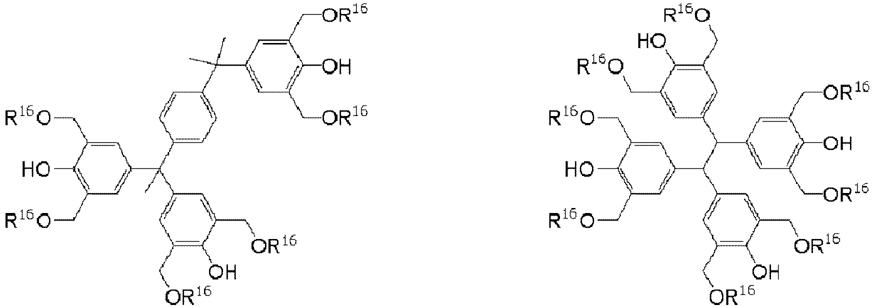

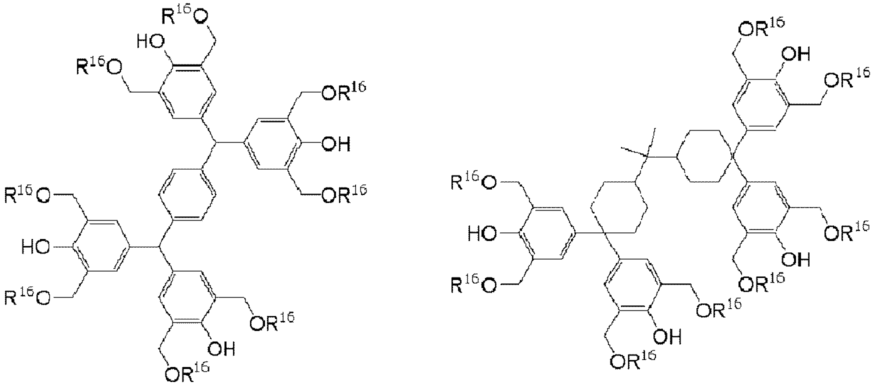

In the formulae, R¹⁶ is as in the formula (10).

### <(D) Acid Generator>

An acid generator (D) can be contained in the inventive composition for forming a metal-containing film in order to promote further the curing reaction of the compound (A) for forming a metal-containing film. Acid generators can be classified into those that generate an acid by thermal decomposition and those that generate an acid by optical irradiation; however, any acid generator can be contained. Specific examples of the acid generator include the materials disclosed in paragraphs [0061] to [0085] of JP2007-199653A, but are not limited thereto.

One kind of the acid generator can be used, or two or more kinds thereof can be used in combination. When the acid generator is contained, the contained amount is preferably 0.05 to 50 parts by mass, more preferably 0.1 to 10 parts by mass based on 100 parts by mass of the compound (A) for forming a metal-containing film.

### <(E) Surfactant>

A surfactant (E) can be contained in the inventive composition for forming a metal-containing film in order to improve coating property in spin-coating. Examples of the surfactant include those disclosed in [0142] to [0147] of JP2009-269953A. When the surfactant is contained, the contained amount is preferably 0.01 to 10 parts by mass, more preferably 0.05 to 5 parts by mass based on 100 parts by mass of the compound (A) for forming a metal-containing film.

### <Method for Forming Metal-Containing Film>

The present invention provides a method of using the above-described composition for forming a metal-containing film to form a resist underlayer film of a multilayer resist film used in lithography or a metal-containing film that serves as a planarizing film for manufacturing a semiconductor.

In the method for forming a metal-containing film by using the inventive composition for forming a metal-containing film, a substrate to be processed is coated with the above-described composition for forming a metal-containing film by a spin-coating method or the like. By using a spin-coating method or the like, an excellent filling property can be achieved. After spin-coating, baking (heating) is performed so as to evaporate the solvent and promote a crosslinking reaction to prevent mixing with a resist upper layer film or a resist middle layer film. The baking is preferably performed at a temperature of 100°C or higher and 600°C or lower for 10 to 600 seconds, more preferably at 150°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a metal-containing film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By virtue of baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Metal-Containing Film>

The present invention provides, as a patterning process according to a multilayer resist process using the above-described composition for forming a metal-containing film, a patterning process for forming a pattern in a substrate to be processed, including the steps of:
(I-1) applying the composition for forming a metal-containing film directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching directly or indirectly while using the resist upper layer film having the formed pattern as a mask; and
(I-5) processing the substrate to be processed directly or indirectly while using the metal-containing film having the formed pattern as a mask to form the pattern in the substrate to be processed.

In the inventive patterning process, it is preferable that at least one organic resist underlayer film is included between the substrate to be processed and the metal-containing film, and the resist upper layer film is preferably formed directly on the metal-containing film.

### (Three-Layer Resist Process)

For example, the present invention provides, as a patterning process according to a three-layer resist process using the above-described composition for forming a metal-containing film, a patterning process including:
forming an organic resist underlayer film on a substrate to be processed by using an organic resist underlayer film material;
forming a metal-containing film on the organic resist underlayer film by using the inventive composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask;
transferring the pattern to the organic resist underlayer film by dry etching while using the metal-containing film having the transferred pattern as a mask; and
processing the substrate to be processed while using the organic resist underlayer film having the formed pattern as a mask to form the pattern in the substrate to be processed.

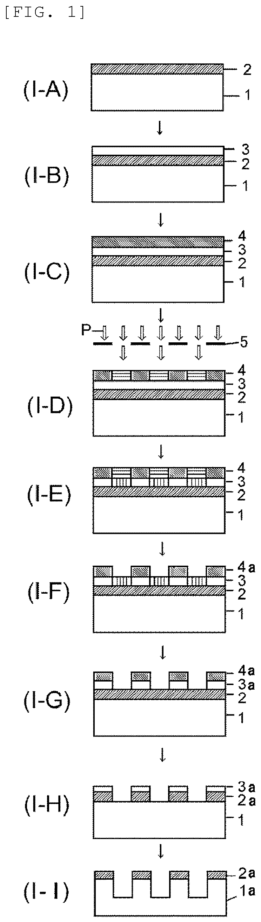

A patterning process according to a three-layer resist process is shown in FIG. 1. Firstly, an organic resist underlayer film 2 is formed by using an organic resist underlayer film material on a substrate 1 to be processed (I-A), then a metal-containing film 3 is formed on the organic resist underlayer film 2 by using the inventive composition for forming a metal-containing film (I-B). Subsequently, a resist upper layer film 4 is formed on the metal-containing film 3 by using a photoresist material (I-C). Exposure P is performed while using a mask 5 (I-D) to expose the resist upper layer film 4 and the metal-containing film 3 (I-E), then a resist upper layer film pattern 4a is formed in the resist upper layer film 4 (I-F). The pattern is transferred to the metal-containing film 3 by dry etching while using the obtained resist upper layer film pattern 4a as a mask (I-G). The resist upper layer film pattern 4a is removed, and then the pattern is transferred to the organic resist underlayer film 2 by dry etching while using the obtained metal-containing film pattern 3a as a mask, thus forming an organic resist underlayer film pattern 2a (I-H). The metal-containing film pattern 3a is removed, and then the substrate 1 to be processed is processed while using the obtained organic resist underlayer film pattern 2a as a mask to form a pattern 1a in the substrate to be processed (I-I).

The resist upper layer film in the three-layer resist process described above exhibits etching resistance with respect to halogen-based gas, such as chlorine-based gas or fluorine-based gas. Therefore, the dry etching of the metal-containing film that is performed while using the resist upper layer film as a mask in the three-layer resist process is preferably performed using an etching gas mainly containing a halogen-based gas.

The metal-containing film in the three-layer resist process described above exhibits etching resistance with respect to oxygen-based gas. Therefore, the dry etching of the organic resist underlayer film that is performed while using the metal-containing film as a mask in the three-layer resist process is preferably performed using an etching gas mainly containing an oxygen-based gas.

The organic resist underlayer film in the three-layer resist process described above exhibits etching resistance with respect to fluorine-based gas. Therefore, the dry etching of the substrate to be processed that is performed while using the organic resist underlayer film as a mask in the three-layer resist process is preferably performed using an etching gas mainly containing a fluorine-based gas.

As the organic resist underlayer film material that can be used for the organic resist underlayer film, it is possible to use: materials already known as materials for an underlayer film for three-layer resist methods or two-layer resist methods using a silicon resist composition; 4,4'-(9-fluorenylidene) bisphenol novolak resin (molecular weight: 11,000) disclosed in JP2005-128509A; and also many resins including novolak resins, known as resist underlayer film materials for two-layer resist methods and three-layer resist methods. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g. JP2004-153125A).

The organic resist underlayer film can be formed on the substrate to be processed by using a composition solution and by a spin-coating method or the like in the same manner as the photoresist composition. After forming the organic underlayer film by a spin-coating method or the like, it is desirable to bake the film in order to evaporate the organic solvent. The baking temperature is preferably 80 to 400°C, and the baking time is preferably 10 to 300 seconds.

Instead of the organic resist underlayer film, it is also possible to adopt an organic hard mask formed by a CVD method or an ALD method.

In the above-described patterning process, the resist upper layer film may be either a positive type or a negative type, and it is possible to use a film similar to the typically used photoresist composition. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is possible to use a patterning process using a photolithography with a wavelength of 5 nm or more and 300 nm or less, a direct drawing using an electron beam, nanoimprinting, or a combination thereof. In the present invention, EUV light is the most preferable.

The development method in the patterning process is preferably alkali development or development using an organic solvent.

Next, etching is performed while using the obtained resist pattern as a mask. The etching of a metal-containing film in the three-layer resist process is performed while using the upper layer resist pattern as a mask by using a chlorine-based or fluorocarbon-based gas. In this manner, a metal-containing film pattern is formed.

Next, the organic resist underlayer film is etched while using the obtained metal-containing film pattern as a mask. The etching of the organic resist underlayer film is preferably performed using an etching gas mainly containing an oxygen-based gas.

A metal-containing film obtained from the inventive composition for forming a metal-containing film has a characteristic of being excellent in etching resistance at the time of the etching of the organic resist underlayer film.

The subsequent etching of the body to be processed may also be performed according to a usual manner. For example, in the case of a body to be processed made of SiO₂, SiN or silica-based low dielectric constant insulating film, the etching is performed mainly based on a fluorocarbon-based gas.

Examples of the body to be processed (substrate to be processed) include, but are not particularly limited to, substrates made of Si, α-Si, p-Si, SiO₂, SiN, SiON, W, TiN, Al, etc., those in which a layer to be processed is formed on the substrate, and the like. Examples of the layer to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

### (Two-Layer Resist Process)

Furthermore, the present invention also provides, as a patterning process according to a two-layer resist process using the above-described composition for forming a metal-containing film, a patterning process including:
forming a metal-containing film on a substrate to be processed by using the composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask; and
processing the substrate to be processed by dry etching while using the metal-containing film having the transferred pattern as a mask to form the pattern in the substrate to be processed.

A metal-containing film obtained from the inventive composition for forming a metal-containing film has a characteristic of being excellent in etching resistance at the time of the etching of the substrate to be processed. Therefore, the dry etching of the substrate to be processed that is performed while using the metal-containing film as a mask in the two-layer resist process is preferably performed using an etching gas mainly containing a fluorine-based gas.

### (Step of Peeling Metal-Containing Film)

Furthermore, the present invention preferably includes, in the patterning process, a step of removing the metal-containing film remaining on the pattern in the film to be processed with a chemical solution after a step of processing the film directly under the metal-containing film (hereinafter, referred to as a film to be processed, and for example, indicates the organic resist underlayer film in the case of the above-described three-layer resist process, and indicates the substrate to be processed in the case of the above-described two-layer resist process) to form the pattern in the film to be processed. When this step is performed after the step of etching the film to be processed, the metal-containing film remaining on the upper side of the substrate is removed. This step can also be performed on the patterned or unpatterned metal-containing film before the step of etching the substrate.

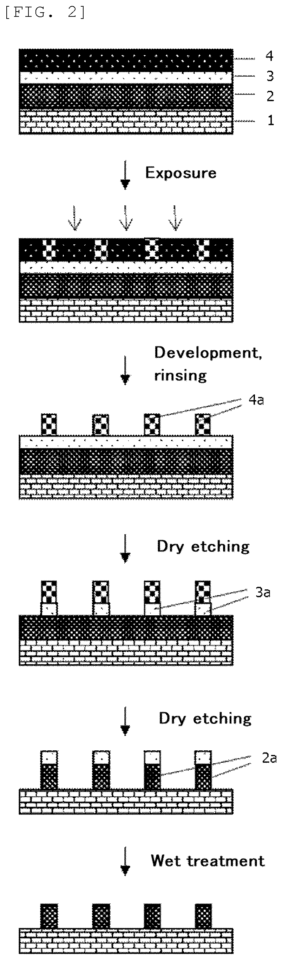

A wet peeling method is shown in FIG. 2. Regarding a body to be processed in which, on a substrate 1 to be processed, an organic resist underlayer film 2, a metal-containing film 3, and a resist upper layer film 4 are formed, firstly, mask exposure is performed on the resist upper layer film 4. Subsequently, development and rinsing are performed to form a resist upper layer film pattern 4a. Subsequently, the pattern is transferred to the metal-containing film 3 by dry etching while using the obtained resist upper layer film pattern 4a as a mask to obtain a metal-containing film pattern 3a. Subsequently, the resist upper layer film pattern 4a is removed, and the pattern is transferred to the organic resist underlayer film 2 by dry etching while using the obtained metal-containing film pattern 3a as a mask to obtain an organic resist underlayer film pattern 2a. Subsequently, the metal-containing film pattern 3a is removed by wet peeling.

It is possible to remove the metal-containing film of the present invention by a wet treatment using a chemical solution, and therefore, a pattern can be formed without damaging the substrate to be processed.

Examples of methods for removing the metal-containing film include: a method of dry-etching the metal-containing film; and a method of allowing a solution, such as a basic solution or an acidic solution, to come into contact with the metal-containing film.

As acid-containing removers, there is no particular limitation as long as they are acidic solutions containing an acid, but from the viewpoint of further enhancing the removability of the metal-containing film, a solution containing a hydrogen peroxide solution and an acid is preferable. More specifically, particularly preferable are: an aqueous solution containing hydrochloric acid and hydrogen peroxide (SC-2 chemical solution); an aqueous solution containing sulfuric acid and hydrogen peroxide (SPM chemical solution); and an aqueous solution containing hydrofluoric acid and hydrogen peroxide (FPM chemical solution).

As base-containing removers, there is no particular limitation as long as they are basic solutions containing a base. Examples of the base include sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide (hereinafter also referred to as "TMAH"), tetraethylammonium hydroxide, pyrrole, piperidine, choline, 1,8-diazabicyclo[5.4.0]-7-undecene, and 1,5-diazabicyclo-[4.3.0]-5-nonene. Among these, from the viewpoint of avoiding damage to the substrate, ammonia is preferable.

As the base-containing removers, a solution containing a base and water or a solution containing a base, a hydrogen peroxide solution, and water is preferable from the viewpoint of further enhancing the removability of the metal-containing film. More specifically, particularly preferable are mixed aqueous solutions of ammonia and hydrogen peroxide (a mixed aqueous solution in which 25% aqueous ammonia solution/30% hydrogen peroxide solution/water = 1/2/40, a mixed aqueous solution in which 25% aqueous ammonia solution/30% hydrogen peroxide solution/water = 1/1/5, etc. (SC1)).

The wet peeling method is not particularly limited as long as the metal-containing film and the peeling chemical solution can be in contact for a certain period under conditions of heating, and examples include: a method of immersing the substrate having the metal-containing film in a heated alkaline hydrogen peroxide solution; a method of spraying an alkaline hydrogen peroxide solution under a heated environment; and a method of applying a heated alkaline hydrogen peroxide solution. After each of these methods, the substrate can be washed with water and dried.

When the step of removing the metal-containing film is performed using a peeling chemical solution, the lower limit of the temperature is preferably 23°C, preferably 40°C, more preferably 50°C. The upper limit of the temperature is preferably 100°C, more preferably 90°C.

In the method using immersion, the lower limit of the immersion time is preferably 1 second, more preferably 10 seconds, further preferably 20 seconds, and particularly preferably 30 seconds. The upper limit of the immersion time is preferably 60 minutes, more preferably 30 minutes, further preferably 20 minutes, and particularly preferably 10 minutes from the viewpoint of suppressing influence on the substrate.

### EXAMPLES

The present invention is further specifically described below with reference to Synthesis Examples, Examples, and Comparative Examples. However, the present invention is not limited to these Examples.

### [Synthesis Examples]

In the following Synthesis Examples, the following organic group raw material group G ((G1) to (G12)) and silicon-containing organic group raw material group H ((H1) and (H2)) were used.

The organic group raw material group G ((G1) to (G12)) is shown below.

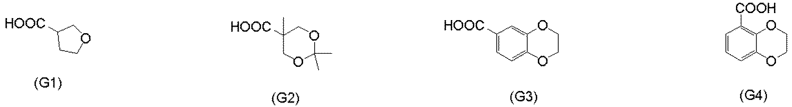

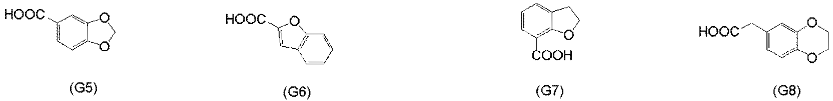

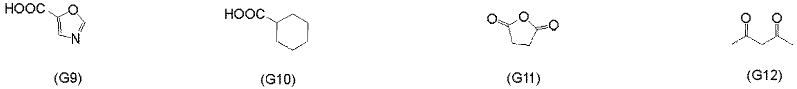

The silicon-containing organic group raw material group H ((H1) and (H2)) is shown below.

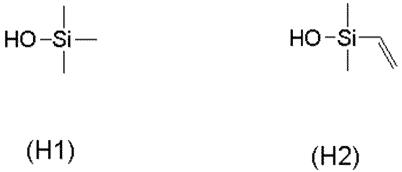

As a metal source M, the following metal compounds were used.
(M1): titanium tetraisopropoxide (377996 available from Sigma-Aldrich Corp)
(M2): Zr(OBu)₄: zirconium(IV) tetrabutoxide (80 mass% solution in 1-butanol) (Z0016 available from Tokyo Chemical Industry Co., Ltd.)
(M3): Hf(OBu)₄: hafnium (IV) n-butoxide (667943 available from Sigma-Aldrich Corp)

### [Synthesis Example 1] Synthesis of Compound (A-1) for Forming Metal-Containing Film

Under a nitrogen atmosphere, 7.10 g of titanium tetraisopropoxide (M1) was dissolved in 15.0 g of a PGMEA/PGME (ratio by weight: 70/30) solution, and while stirring, the reaction temperature was raised to 60°C. A mixture obtained by suspending 2.90 g of the compound G1 in 5.50 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-1) for forming a metal-containing film in PGMEA/PGME was obtained.

### [Synthesis Examples 2 to 12] Synthesis of Compounds (A-2) to (A-9) and (R-1) to (R-3) for Forming Metal-Containing Film

The compounds (A-2) to (A-9) and (R-1) to (R-3) for forming a metal-containing film shown in Table 1 were obtained under the same reaction conditions as in [Synthesis Example 1], except that the metal source M and the organic group raw material group G were used at the charging amounts shown in Table 1. (A-1) is also shown in Table 1.

**[Table 1]**

| Synthesis Example | Metal compound | | Organic ligand | | Compound for forming metal-containing film |
|---|---|---|---|---|---|
| | Symbol | g | Symbol | g | |
| 1 | M1 | 7.10 | G1 | 2.90 | A-1 |
| 2 | M2 | 12.00 | G2 | 4.35 | A-2 |
| 3 | M3 | 11.89 | G3 | 4.50 | A-3 |
| 4 | M1 | 7.10 | G4 | 4.50 | A-4 |
| 5 | M2 | 12.00 | G5 | 4.15 | A-5 |
| 6 | M3 | 11.89 | G6 | 3.50 | A-6 |
| 7 | M1 | 7.10 | G7 | 4.50 | A-7 |
| 8 | M2 | 12.00 | G8 | 4.85 | A-8 |
| 9 | M3 | 11.89 | G9 | 2.83 | A-9 |
| 10 | M1 | 7.10 | G10 | 3.20 | R-1 |
| 11 | M2 | 12.00 | G11 | 2.50 | R-2 |
| 12 | M3 | 11.89 | G12 | 2.50 | R-3 |

### [Synthesis Example 13] Synthesis of Compound (A-10) for Forming Metal-Containing Film

Under a nitrogen atmosphere, 7.10 g of titanium tetraisopropoxide (M1) was dissolved in 15.00 g of a PGMEA/PGME (ratio by weight: 70/30) solution, and while stirring, the reaction temperature was raised to 50°C, and 6.76 g of the compound H1 was added dropwise to the solution. After the addition, the reaction temperature was set to 60°C, and stirring was continued for 2 hours. Subsequently, a mixture obtained by suspending 4.50 g of the compound G4 in 5.50 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-10) for forming a metal-containing film in PGMEA/PGME was obtained.

### [Synthesis Example 14] Synthesis of Compound (A-11) for Forming Metal-Containing Film

The compound (A-11) shown in Table 2 was obtained under the same reaction conditions as in [Synthesis Example 13], except that the metal source M, the organic group raw material group G, and the silicon-containing organic group raw group H were used at the charging amounts shown in Table 2. (A-10) is also shown.

**[Table 2]**

| Synthesis Example | Metal compound | | Organic ligand | | Silicon-containing ligand | | Compound for forming metal-containing film |
|---|---|---|---|---|---|---|---|
| | Symbol | g | Symbol | g | Symbol | g | |
| 13 | M1 | 7.10 | G4 | 4.50 | H1 | 6.76 | A-10 |
| 14 | M2 | 12.00 | G5 | 4.15 | H1 | 6.76 | A-11 |

### [Synthesis Example 15] Synthesis of Compound (A-12) for Forming Metal-Containing Film

Under a nitrogen atmosphere, 35.53 g of titanium tetraisopropoxide (M1) was dissolved in 50.00 g of 2-propanol, and while stirring, a solution of 1.69 g of deionized water in 70.0 g of 2-propanol was added dropwise at room temperature over 2 hours. To the obtained solution, 22.52 g of the compound G4 was added, and the mixture was agitated at room temperature for 30 minutes. After the solution was concentrated under reduced pressure at 30°C, it was further heated to 60°C and heating was continued under reduced pressure to generate no distillate. When a distillate was no longer observed, 100.50 g of a PGMEA/PGME (ratio by weight: 70/30) solution was added thereto and heated under reduced pressure at 40°C until no IPA was distilled. Thus, a solution of a compound (A-12) for forming a metal-containing film in PGMEA/PGME was obtained.

### [Synthesis Example 16] Synthesis of Compound (A-13) for Forming Metal-Containing Film

The compound (A-13) shown in Table 3 was obtained under the same reaction conditions as in [Synthesis Example 15], except that the metal source M and the organic group raw material group G were used at the charging amounts shown in Table 3. (A-12) is also shown.

**[Table 3]**

| Synthesis Example | Metal compound | | Organic ligand | | Compound for forming metal-containing film |
|---|---|---|---|---|---|
| | Symbol | g | Symbol | g | |
| 15 | M1 | 35.53 | G4 | 22.52 | A-12 |
| 16 | M2 | 59.95 | G5 | 20.77 | A-13 |

### Preparation of Composition (UDL-1 to -16 and Comparative UDL-1 to -3) for Forming Metal-Containing Film

For the preparation of compositions for forming a metal-containing film, the following were used: the compounds (A-1) to (A-13) for forming a metal-containing film; (D-1) as an acid generator; (XL-1) and (XL-2) as crosslinking agents; and F1 (ethylene glycol dibenzyl ether, having a boiling point of 364°C) as a high-boiling-point solvent (B1). These were dissolved in an organic solvent in proportions shown in Table 4, and then the solution was filtered through a 0.1-µm filter made of a fluororesin to prepare each of the compositions (UDL-1 to -16 and comparative UDL-1 to -3) for forming a metal-containing film.

(**CH**₃**CH**₂)₃**N⁺H C**₄**F**₉**SO**₃⁻ (**D-1**)

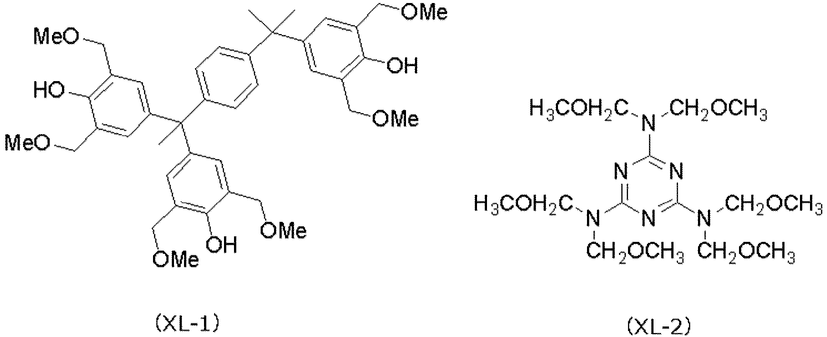

**[Table 4]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (3) | - | PGMEA/PGME (77/20) |
| UDL-2 | A-2 (3) | - | PGMEA/PGME (77/20) |
| UDL-3 | A-3 (3) | - | PGMEA/PGME (77/20) |
| UDL-4 | A-4 (3) | - | PGMEA/PGME (77/20) |
| UDL-5 | A-5 (3) | - | PGMEA/PGME (77/20) |
| UDL-6 | A-6 (3) | - | PGMEA/PGME (77/20) |
| UDL-7 | A-7 (3) | - | PGMEA/PGME (77/20) |
| UDL-8 | A-8 (3) | - | PGMEA/PGME (77/20) |
| UDL-9 | A-9 (3) | - | PGMEA/PGME (77/20) |
| UDL-10 | A-10 (3) | - | PGMEA/PGME (77/20) |
| UDL-11 | A-11 (3) | - | PGMEA/PGME (77/20) |
| UDL-12 | A-12 (3) | - | PGMEA/PGME (77/20) |
| UDL-13 | A-13 (3) | - | PGMEA/PGME (77/20) |
| UDL-14 | A-14 (3) | F-1 (5) | PGMEA/PGME (77/20) |
| UDL-15 | A-15 (3) | XL-1 (2) | PGMEA/PGME (77/20) |
| UDL-16 | A-16 (3) | XL-2 (2) D-1 (0.2) | PGMEA/PGME (77/20) |
| Comparative UDL-1 | R-1 (3) | - | PGMEA/PGME (77/20) |
| Comparative UDL-2 | R-2 (3) | - | PGMEA/PGME (77/20) |
| Comparative UDL-3 | R-3 (3) | - | PGMEA/PGME (77/20) |

### [Etching Resistance Evaluation (Examples 1-1 to 1-16 and Comparative Examples 1-1 to 1-5)]

Each of the compositions (UDL-1 to -16 and comparative UDL-1 to -3) for forming a metal-containing film was respectively applied onto a silicon substrate and heated by using a hot plate at 250°C for 60 seconds to form a metal-containing film having a film thickness of 30 nm (film thickness "a").

In Comparative Example 1-4, the following silicon-containing resist middle layer film composition (SOG-1) was applied and baked at 220°C for 60 seconds to form a resist middle layer film having a film thickness of 30 nm (film thickness "a").

The silicon-containing resist middle layer film composition (SOG-1) was prepared by dissolving an ArF silicon-containing middle layer film polymer represented by (SiP1) and a thermal crosslinking catalyst (CAT1) in a solvent containing 0.1 mass% of FC-4430 (available from Sumitomo 3M Limited) in the proportion shown in Table 5; and filtering the solution through a filter made of a fluororesin and having a pore size of 0.1 µm.

**[Table 5]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

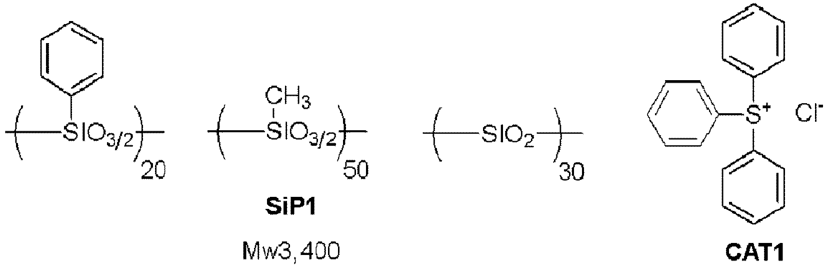

In Comparative Example 1-5, the following organic resist underlayer film composition (SOC-1) was applied and baked at 350°C for 60 seconds to form a resist underlayer film having a film thickness of 50 nm (film thickness "a").

The organic resist underlayer film composition (SOC-1) was prepared by dissolving an organic underlayer film polymer represented by (CP1) in a solvent containing 0.1 mass% of FC-4430 (available from Sumitomo 3M Limited) in the proportion shown in Table 6; and filtering the solution through a filter made of a fluororesin and having a pore size of 0.1 µm.

**[Table 6]**

| | Polymer | Solvent 1 |
|---|---|---|
| | (parts by mass) | (parts by mass) |
| SOC-1 | CP1 | Propylene glycol monoethyl ether |
| | (100) | (3000) |

The structural formula of the used organic underlayer film polymer (CP1) is shown below. 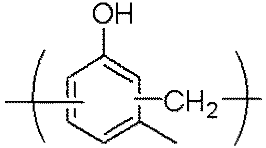 Mw=7,000, Mw/Mn=3.50

Subsequently, using an etching apparatus CE-300I manufactured by ULVAC, Inc., etching using a CF₄ gas and O₂ gas was each performed under the following conditions, and the film thickness "b" was measured. Then, the film thickness etched in one minute was calculated as an etching rate (nm/min) from the film thickness etched (film thickness "a" - film thickness "b") using the respective gas in a specified time.

When the etching rate to CF₄ gas was lower than 20 nm/min, the evaluation "A (very good)" was given, when 20 nm/min or higher and lower than 30 nm/min, "B (good)", and when 30 nm/min or higher, "C (poor)".

When the etching rate to O₂ gas was lower than 20 nm/min, the evaluation "A (very good)" was given, when 20 nm/min or higher and lower than 30 nm/min, "B (good)", and when 30 nm/min or higher, "C (poor)".

Table 7 shows the results.

### Conditions of dry etching with CF₄ gas

Pressure: 3 Pa
Antenna RF power: 100 W
Bias RF power: 15 W
CF₄ gas flow rate: 15 sccm
Time: 30 sec

### Conditions of dry etching with O₂ gas

Pressure: 3 Pa
Antenna RF power: 300 W
Bias RF power: 10 W
O₂ gas flow rate: 25 sccm
Time: 30 sec

**[Table 7]**

| Example | Composition for forming metal-containing film | Baking temperature | Etching rate (nm/min) | Etching rate (nm/min) |
|---|---|---|---|---|
| | | °C | CF₄ | O₂ |
| Example 1-1 | UDL-1 | 250°C | A | A |
| Example 1-2 | UDL-2 | 250°C | A | A |
| Example 1-3 | UDL-3 | 250°C | A | A |
| Example 1-4 | UDL-4 | 250°C | A | A |
| Example 1-5 | UDL-5 | 250°C | A | A |
| Example 1-6 | UDL-6 | 250°C | A | A |
| Example 1-7 | UDL-7 | 250°C | A | A |
| Example 1-8 | UDL-8 | 250°C | A | A |
| Example 1-9 | UDL-9 | 250°C | A | A |
| Example 1-10 | UDL-10 | 250°C | A | A |
| Example 1-11 | UDL-11 | 250°C | A | A |
| Example 1-12 | UDL-12 | 250°C | A | A |
| Example 1-13 | UDL-13 | 250°C | A | A |
| Example 1-14 | UDL-14 | 250°C | A | A |
| Example 1-15 | UDL-15 | 250°C | A | A |
| Example 1-16 | UDL-16 | 250°C | A | A |
| Comparative Example 1-1 | Comparative UDL-1 | 250°C | A | A |
| Comparative Example 1-2 | Comparative UDL-2 | 250°C | A | A |
| Comparative Example 1-3 | Comparative UDL-3 | 250°C | A | A |
| Comparative Example 1-4 | SOG-1 | 220°C | C | A |
| Comparative Example 1-5 | SOC-1 | 250°C | B | C |

As shown in Table 7, it was shown that the inventive compositions (UDL-1 to -16) for forming a metal-containing film all exhibited excellent etching resistance to CF₄ gas and O₂ gas.

The results of the Examples are better than those of SOG-1, used in Comparative Example 1-4, regarding resistance to etching using CF₄ gas, and therefore, it can be said that the compositions are suitable for a three-layer resist process, where a resist pattern is transferred to a substrate to be processed by employing a combination with an organic resist underlayer film.

The results of the Examples are better than those of SOC-1, used in Comparative Example 1-5, regarding resistance to etching with O₂ gas, and therefore, it can be said that the compositions are suitable for a two-layer resist process, where a resist pattern is transferred to a substrate to be processed by employing a combination with a photoresist upper layer film.

### [Coating Film Wet Etching Test (Examples 2-1 to 2-16 and Comparative Examples 2-1 to 2-4)]

Each of the compositions (UDL-1 to -16 and comparative UDL-1 to -3) for forming a metal-containing film was respectively applied onto a silicon substrate and heated by using a hot plate at 250°C for 60 seconds to form a metal-containing film having a film thickness of 30 nm. These metal-containing films were immersed in a basic solution (mixed aqueous solution in which 25% aqueous ammonia solution/30% hydrogen peroxide solution/water = 1/1/5) at 65°C for 2 minutes, the thickness of the remaining film was measured with a high-speed spectroscopic ellipsometer M-2000 manufactured by J. A. Woollam Japan, and it was evaluated whether or not there was change in the film thickness between before and after the immersion in the basic solution. When the change in film thickness was 70% or more, the evaluation "Good" was given, and when the change in film thickness was less than 70%, "Poor".

Table 8 shows the results.

**[Table 8]**

| Example | Composition for forming metal-containing film | Baking temperature | Wet peeling property SC1 |
|---|---|---|---|
| | | °C | |
| Example 2-1 | UDL-1 | 250°C | Good |
| Example 2-2 | UDL-2 | 250°C | Good |
| Example 2-3 | UDL-3 | 250°C | Good |
| Example 2-4 | UDL-4 | 250°C | Good |
| Example 2-5 | UDL-5 | 250°C | Good |
| Example 2-6 | UDL-6 | 250°C | Good |
| Example 2-7 | UDL-7 | 250°C | Good |
| Example 2-8 | UDL-8 | 250°C | Good |
| Example 2-9 | UDL-9 | 250°C | Good |
| Example 2-10 | UDL-10 | 250°C | Good |
| Example 2-11 | UDL-11 | 250°C | Good |
| Example 2-12 | UDL-12 | 250°C | Good |
| Example 2-13 | UDL-13 | 250°C | Good |
| Example 2-14 | UDL-14 | 250°C | Good |
| Example 2-15 | UDL-15 | 250°C | Good |
| Example 2-16 | UDL-16 | 250°C | Good |
| Comparative Example 2-1 | Comparative UDL-1 | 250°C | Poor |
| Comparative Example 2-2 | Comparative UDL-2 | 250°C | Poor |
| Comparative Example 2-3 | Comparative UDL-3 | 250°C | Poor |
| Comparative Example 2-4 | SOG-1 | 220°C | Poor |

As shown in Table 8, the inventive compositions (UDL-1 to -16) for forming a metal-containing film had better peeling property when using a basic solution compared to the metal-containing films formed using comparative UDL-1 to -3, not containing a ligand having a particular cyclic structure (t), and compared to the silicon-containing film formed from SOG-1. It is conjectured that permeability of the peeling solution was enhanced because a ligand having a particular cyclic structure (t) was contained. Incidentally, comparative UDL-2 uses R-2, and R-2 has a ligand derived from G11. However, although G11 has a cyclic structure (t), the ligand derived therefrom is ring-opened, and does not have a cyclic structure (t).

### [Patterning Test (Examples 3-1 to 3-16 and Comparative Examples 3-1 to 3-4)]

An SOC film (ODL-306, carbon content: 61 atomic%) manufactured by Shin-Etsu Chemical Co., Ltd. was applied as an organic resist underlayer film by spin-coating on silicon wafers on which a 100-nm SiO₂ film had been formed, and baked at 350°C for 60 seconds to prepare a carbon film having a film thickness of 50 nm. Subsequently, each of the compositions (UDL-1 to -16 and comparative UDL-1 to -3) for forming a metal-containing film and SOG-1 was respectively applied onto the organic resist underlayer films, and heated by using a hot plate at 250°C or 220°C for 60 seconds to form a resist middle layer film having a film thickness of 30 nm.

Subsequently, the resist material shown in Table 9 was applied onto the metal-containing film by spin-coating, and prebaked by using a hot plate at 105°C for 60 seconds to prepare a resist film having a film thickness of 40 nm. The resist film was exposed using an EUV scanner NXE3300 (manufactured by ASML, NA: 0.33, σ: 0.9/0.6, dipole illumination, with an L/S pattern having a pitch of 36 nm (on-wafer size)), followed by PEB on a hot plate at 100°C for 60 seconds and development with a 2.38 mass% aqueous solution of TMAH for 30 seconds to obtain a pattern with a line size of 22 nm.

This line size was measured using CD-SEM (CG5000) manufactured by Hitachi High-Technologies Corp. to observe whether there was pattern collapse. When no pattern collapse was observed, the pattern was evaluated as good, and pattern collapse was observed, as poor. In addition, the cross-sectional profile was observed with an electron microscope (S-4800) manufactured by Hitachi High-Technologies Corp., and when no trailing profile was found, the profile was evaluated as good, and when an obvious trailing profile was found, as poor.

In addition, an exposure dose at which a line size of 18 nm was achieved was evaluated as sensitivity, and it was judged that, the smaller the exposure dose, the greater the contribution to the achievement of higher sensitivity of the resist upper layer film.

Table 10 shows the results.

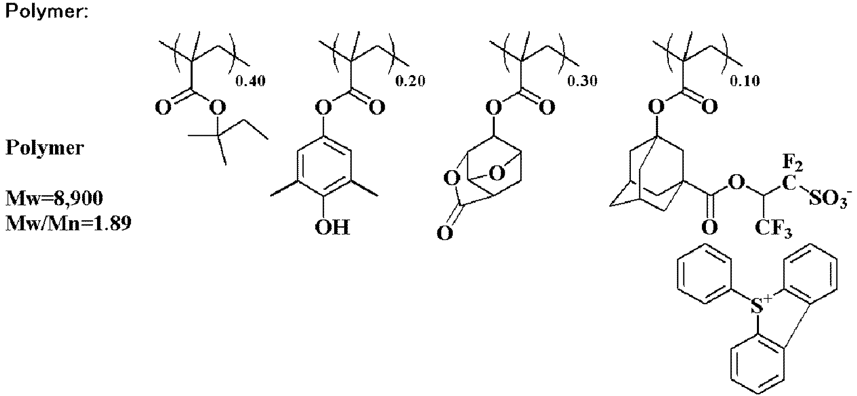

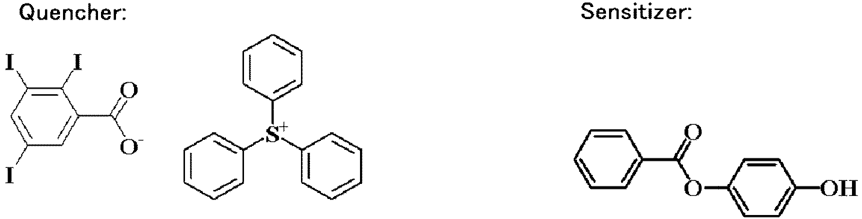

### Surfactant: FC-4430 available from 3M

**[Table 9]**

| Component | Polymer | Quencher | Sensitizer | Surfactant | Organic solvent |
|---|---|---|---|---|---|
| Composition (parts by mass) | (100) | (4.0) | (2.1) | (0.25) | PGMEA (400) |
| | | | | | CyHO (2000) |
| | | | | | PGME (100) |

| | | | | | |
|---|---|---|---|---|---|
| · Organic solvents: PGMEA (propylene glycol monomethyl ether acetate) CyHO (cyclohexanone) PGME (propylene glycol monomethyl ether) | | | | | |

**[Table 10]**

| Example | Composition for forming metal-containing film | Baking temperature | L/S patterning test | |
|---|---|---|---|---|
| | | °C | Sensitivity | Cross section after development |
| Example 3-1 | UDL-1 | 250°C | 44.2 | Rectangular |
| Example 3-2 | UDL-2 | 250°C | 45.4 | Rectangular |
| Example 3-3 | UDL-3 | 250°C | 43.8 | Rectangular |
| Example 3-4 | UDL-4 | 250°C | 44.1 | Rectangular |
| Example 3-5 | UDL-5 | 250°C | 45.2 | Rectangular |
| Example 3-6 | UDL-6 | 250°C | 43.8 | Rectangular |
| Example 3-7 | UDL-7 | 250°C | 43.9 | Rectangular |
| Example 3-8 | UDL-8 | 250°C | 45.3 | Rectangular |
| Example 3-9 | UDL-9 | 250°C | 44 | Rectangular |
| Example 3-10 | UDL-10 | 250°C | 44.1 | Rectangular |
| Example 3-11 | UDL-11 | 250°C | 45.1 | Rectangular |
| Example 3-12 | UDL-12 | 250°C | 44 | Rectangular |
| Example 3-13 | UDL-13 | 250°C | 45 | Rectangular |
| Example 3-14 | UDL-14 | 250°C | 45.2 | Rectangular |
| Example 3-15 | UDL-15 | 250°C | 45.1 | Rectangular |
| Example 3-16 | UDL-16 | 250°C | 45 | Rectangular |
| Comparative Example 3-1 | Comparative UDL-1 | 250°C | - | Pattern collapse |
| Comparative Example 3-2 | Comparative UDL-2 | 250°C | - | Pattern collapse |
| Comparative Example 3-3 | Comparative UDL-3 | 250°C | - | Pattern collapse |
| Comparative Example 3-4 | SOG-1 | 220°C | 47.8 | Trailing profile |

As shown in Table 10, it was observed that the inventive compositions (UDL-1 to -16) for forming a metal-containing film successfully achieved a pattern cross section having a vertical profile in the formation of the pattern having a line width of 22 nm by using EUV exposure, and there was no pattern collapse. It is conjectured that the adhesiveness to the resist pattern was enhanced since the inventive compounds for forming a metal-containing film contained a ligand having a particular cyclic structure (t). In addition, it is conjectured that the permeability of the developer was enhanced, and a highly rectangular resist pattern was obtained after the development. Furthermore, it was found that when a metal-containing film obtained from the inventive composition for forming a metal-containing film was used as a resist underlayer film, it was possible to form a resist pattern with high sensitivity.

On the other hand, it was found that the metal-containing films (Comparative Examples 3-1 to 3-3) formed using compounds for forming a metal-containing film different from the present invention had a smaller effect of suppressing the collapse of a fine pattern compared to the metal-containing films (Examples 3-1 to 3-16) obtained from the inventive compositions for forming a metal-containing film. In Comparative Example 3-4, where SOG-1 was used, pattern collapse was not observed, but the cross-sectional profile of the resist was a trailing profile.

As described above, a composition for forming a metal-containing film containing the inventive compound for forming a metal-containing film makes it possible to form a metal-containing film having excellent adhesiveness to an upper layer resist, and therefore, having a high effect of suppressing fine pattern collapse, and also being capable of contributing to the enhancement of the sensitivity of the upper layer resist, and can be easily removed. Therefore, the composition has a high utility value in the field of EUV lithography.

The present description includes the following embodiments.
[1] A compound for forming a metal-containing film, comprising:
   at least one metal atom selected from the group consisting of Ti, Zr, and Hf; and a ligand coordinated to the metal atom via an oxygen atom, wherein
   the ligand has a cyclic structure (t) selected from
   a ring having 4 or more carbon atoms and containing 1 or more oxygen atoms,
   a ring having 3 or more carbon atoms and containing 2 or more oxygen atoms, and
   a ring having 3 or more carbon atoms and containing 1 or more oxygen atoms and 1 or more heteroatoms other than oxygen atoms.
[2] The compound for forming a metal-containing film according to [1], wherein the cyclic structure (t) contains a ring having 4 or more carbon atoms and containing 2 or more oxygen atoms, or a ring having 4 or more carbon atoms and containing 1 or more oxygen atoms and 1 or more heteroatoms other than oxygen atoms.
[3] The compound for forming a metal-containing film according to [1] or [2], wherein the cyclic structure (t) forms a polycyclic structure by being bonded to any one or more of: a cyclic hydrocarbon having 4 to 6 carbon atoms and optionally containing a heteroatom; a cyclic hydrocarbon having 5 or 6 carbon atoms, having one or more carbon-carbon double bonds, and optionally containing a heteroatom; an aromatic ring; and an aromatic heterocycle.
[4] The compound for forming a metal-containing film according to any one of [1] to [3], wherein the cyclic structure (t) is a derivative of an organic acid containing the cyclic structure (t).
[5] The compound for forming a metal-containing film according to [4], wherein the organic acid is a carboxylic acid.
[6] The compound for forming a metal-containing film according to any one of [1] to [5], wherein the ligand is a derivative of the following structure,

   Ra(X)ₙCOOH (1)

   wherein Ra represents a monovalent organic group containing the cyclic structure (t); X represents a group selected from a substituted or unsubstituted alkylene group having 1 to 10 carbon atoms, a substituted or unsubstituted, branched alkylene group having 3 to 10 carbon atoms, a substituted or unsubstituted alkylene group having 2 to 10 carbon atoms and containing a carbon-carbon double bond, and a substituted or unsubstituted, branched alkylene group having 3 to 10 carbon atoms and containing a carbon-carbon double bond; and "n" represents 0 or 1.
[7] The compound for forming a metal-containing film according to any one of [1] to [6], further comprising a ligand which is a derivative of a silicon compound represented by the following general formula (w), 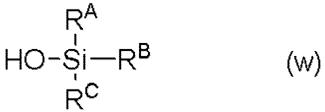 wherein R^{A}, R^{B}, and R^{C} each represent any organic group selected from an organic group having 2 to 30 carbon atoms including a crosslinking group of a structure represented by any of the following general formulae (w-1) to (w-3), a substituted or unsubstituted alkyl group having 1 to 20 carbon atoms, and an aryl group having 6 to 20 carbon atoms, 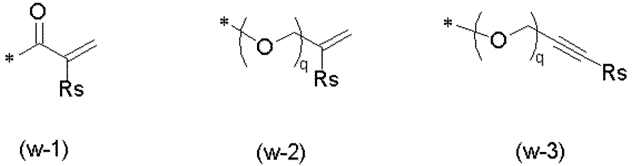 wherein Rₛ represents a hydrogen atom or a monovalent organic group having 1 to 10 carbon atoms; "q" represents 0 or 1; and "*" represents an attachment point.
[8] The compound for forming a metal-containing film according to any one of [1] to [7], wherein the compound for forming a metal-containing film is a reaction product of: a metal compound represented by the following formula (a) or a metal-containing compound containing any of a hydrolysate, condensate, and hydrolysis condensate of the metal compound represented by the following formula (a); and a compound having the cyclic structure (t),

   **LₐMX_{b}** **(a)**

   wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b is 2 to 4, "a" and "b" each representing an integer of 0 to 4.
[9] The compound for forming a metal-containing film according to [8], wherein the formula (a) has a structure of the following formula (a-1),

   M(OR^{1A})₄ (a-1)

   wherein M represents any of Ti, Zr, and Hf; and R^{1A} represents a monovalent organic group having 1 to 20 carbon atoms.
[10] A composition for forming a metal-containing film, the composition functioning as a metal-containing film material used in manufacturing a semiconductor, the composition comprising: (A) the compound for forming a metal-containing film according to any one of [1] to [9]; and (B) an organic solvent.
[11] The composition for forming a metal-containing film according to [10], further comprising one or more of (C) a crosslinking agent, (D) an acid generator, and (E) a surfactant.
[12] The composition for forming a metal-containing film according to [10] or [11], wherein the organic solvent (B) contains, as (B1) a high-boiling-point solvent, one or more kinds of organic solvent having a boiling point of 180°C or higher.
[13] A patterning process for forming a pattern in a substrate to be processed, comprising the steps of:
   (I-1) applying the composition for forming a metal-containing film according to any one of [10] to [12] directly or indirectly onto a substrate to be processed, followed by heating to form a metal-containing film;
   (I-2) forming a resist upper layer film directly or indirectly on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching directly or indirectly while using the resist upper layer film having the formed pattern as a mask; and
   (I-5) processing the substrate to be processed directly or indirectly while using the metal-containing film having the formed pattern as a mask to form the pattern in the substrate to be processed.
[14] The patterning process according to [13], wherein at least one organic resist underlayer film is included between the substrate to be processed and the metal-containing film.
[15] The patterning process according to [13] or [14], wherein the resist upper layer film is formed directly on the metal-containing film.
[16] The patterning process according to any one of [13] to [15], further comprising, after a step of processing a film directly under the metal-containing film while using the metal-containing film as a mask to form the pattern, a step of removing the metal-containing film with a chemical solution.
[17] The patterning process according to [16], wherein a solution containing a hydrogen peroxide solution and an acid or a solution containing a base, a hydrogen peroxide solution, and water is used as the chemical solution.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A compound for forming a metal-containing film, comprising:
at least one metal atom selected from the group consisting of Ti, Zr, and Hf; and a ligand coordinated to the metal atom via an oxygen atom, wherein
the ligand has a cyclic structure (t) selected from
a ring having 4 or more carbon atoms and containing 1 or more oxygen atoms,
a ring having 3 or more carbon atoms and containing 2 or more oxygen atoms, and
a ring having 3 or more carbon atoms and containing 1 or more oxygen atoms and 1 or more heteroatoms other than oxygen atoms.

2. The compound for forming a metal-containing film according to claim 1, wherein the cyclic structure (t) contains a ring having 4 or more carbon atoms and containing 2 or more oxygen atoms, or a ring having 4 or more carbon atoms and containing 1 or more oxygen atoms and 1 or more heteroatoms other than oxygen atoms.

3. The compound for forming a metal-containing film according to claim 1 or 2, wherein the cyclic structure (t) forms a polycyclic structure by being bonded to any one or more of: a cyclic hydrocarbon having 4 to 6 carbon atoms and optionally containing a heteroatom; a cyclic hydrocarbon having 5 or 6 carbon atoms, having one or more carbon-carbon double bonds, and optionally containing a heteroatom; an aromatic ring; and an aromatic heterocycle.

4. The compound for forming a metal-containing film according to any one of claims 1 to 3, wherein the cyclic structure (t) is a derivative of an organic acid containing the cyclic structure (t), and
prefereably wherein the organic acid is a carboxylic acid.

5. The compound for forming a metal-containing film according to any one of claims 1 to 4, wherein the ligand is a derivative of the following structure,
Ra(X)ₙCOOH (1)
wherein Ra represents a monovalent organic group containing the cyclic structure (t); X represents a group selected from a substituted or unsubstituted alkylene group having 1 to 10 carbon atoms, a substituted or unsubstituted, branched alkylene group having 3 to 10 carbon atoms, a substituted or unsubstituted alkylene group having 2 to 10 carbon atoms and containing a carbon-carbon double bond, and a substituted or unsubstituted, branched alkylene group having 3 to 10 carbon atoms and containing a carbon-carbon double bond; and "n" represents 0 or 1.

6. The compound for forming a metal-containing film according to any one of claims 1 to 5, further comprising a ligand which is a derivative of a silicon compound represented by the following general formula (w), 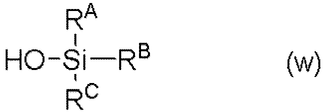 wherein R^{A}, R^{B}, and R^{C} each represent any organic group selected from an organic group having 2 to 30 carbon atoms including a crosslinking group of a structure represented by any of the following general formulae (w-1) to (w-3), a substituted or unsubstituted alkyl group having 1 to 20 carbon atoms, and an aryl group having 6 to 20 carbon atoms, 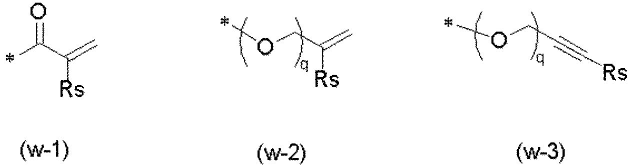 wherein Rₛ represents a hydrogen atom or a monovalent organic group having 1 to 10 carbon atoms; "q" represents 0 or 1; and "*" represents an attachment point.

7. The compound for forming a metal-containing film according to any one of claims 1 to 6, wherein the compound for forming a metal-containing film is a reaction product of: a metal compound represented by the following formula (a) or a metal-containing compound containing any of a hydrolysate, condensate, and hydrolysis condensate of the metal compound represented by the following formula (a); and a compound having the cyclic structure (t),
**LₐMX_{b}** **(a)**
wherein M represents any of Ti, Zr, and Hf, L represents a monodentate ligand having 1 to 30 carbon atoms or a polydentate ligand having 1 to 30 carbon atoms, X represents a hydrolysable group selected from a halogen atom, an alkoxy group, a carboxylate group, an acyloxy group, and -NR¹R², R¹ and R² each independently represent a hydrogen atom or a monovalent organic group having 1 to 20 carbon atoms, and a+b is 2 to 4, "a" and "b" each representing an integer of 0 to 4.

8. The compound for forming a metal-containing film according to claim 7, wherein the formula (a) has a structure of the following formula (a-1),
M(OR^{1A})₄ (a-1)
wherein M represents any of Ti, Zr, and Hf; and R^{1A} represents a monovalent organic group having 1 to 20 carbon atoms.

9. A composition for forming a metal-containing film, the composition functioning as a metal-containing film material used in manufacturing a semiconductor, the composition comprising: (A) the compound for forming a metal-containing film according to any one of claims 1 to 8; and (B) an organic solvent.

10. The composition for forming a metal-containing film according to claim 9, further comprising one or more of (C) a crosslinking agent, (D) an acid generator, and (E) a surfactant.

11. The composition for forming a metal-containing film according to claim 9 or 10, wherein the organic solvent (B) contains, as (B1) a high-boiling-point solvent, one or more kinds of organic solvent having a boiling point of 180°C or higher.

12. A patterning process for forming a pattern in a substrate to be processed, comprising the steps of:
(I-1) applying the composition for forming a metal-containing film according to any one of claims 9 to 11 directly or indirectly onto a substrate to be processed, followed by heating to form a metal-containing film;
(I-2) forming a resist upper layer film directly or indirectly on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching directly or indirectly while using the resist upper layer film having the formed pattern as a mask; and
(I-5) processing the substrate to be processed directly or indirectly while using the metal-containing film having the formed pattern as a mask to form the pattern in the substrate to be processed.

13. The patterning process according to claim 12, wherein at least one organic resist underlayer film is included between the substrate to be processed and the metal-containing film.

14. The patterning process according to claim 12 or 13, wherein the resist upper layer film is formed directly on the metal-containing film.

15. The patterning process according to any one of claims 12 to 14, further comprising, after a step of processing a film directly under the metal-containing film while using the metal-containing film as a mask to form the pattern, a step of removing the metal-containing film with a chemical solution, and
preferably wherein a solution containing a hydrogen peroxide solution and an acid or a solution containing a base, a hydrogen peroxide solution, and water is used as the chemical solution.
